# EUROPÄISCHE PATENTANMELDUNG

(11) **EP 1 093 155 A2**
(43) Veröffentlichungstag der Anmeldung: **18.04.2001**
(21) Anmeldenummer: 00121931.0
(22) Anmeldetag: 09.10.2000
(51) Int. Cl.: H01L 21/00

(54) **Vorrichtung und Verfahren zum Laden von Substraten verschiedener Grösse in Substrathalter**

(30) Priorität: 11.10.1999 DE 19949008
(71) Anmelder: Leica Microsystems Wetzlar GmbH, 35578 Wetzlar (DE)
(72) Erfinder: Bläsing-Bangert, Carola, 35625 Hüttenberg (DE); Kaczynski, Ulrich, 61231 Bad Nauheim (DE)
(74) Vertreter: Reichert, Werner F., Dr.

(57) **Zusammenfassung**

Vorrichtung und Verfahren zum Laden von Substraten (8) verschiedener Größe in einen Substrathalter (50). Die Vorrichtung dazu umfasst eine Bodenplatte (22) mit umlaufenden Rand (24) und mindestens drei auf der Bodenplatte (22) angeordnete Tragmittel (26), von denen jedes unterschiedliche Auflageflächen (36, 38 und 42) für die verschiedenen Substrate (8) ausgebildet hat. Die Auflageflächen (36, 38 und 42) sind an den Tragmitteln (26) stufenförmig angeordnet. Ferner sind Aufnahmeelemente (28) für den Substrathalter (50) auf der Bodenplatte (26) derart angeordnet, dass der aufgelegte Substrathalter (50) die Tragmittel (26) umschließt und in seiner Lage ausgerichtet und orientiert ist. In mindestens einer der Auflageflächen (36, 38 und 42) eines Tragmittels (26) für eine Substratgröße ist mindestens ein Sensorelement (44) untergebracht, um damit die Größe des Substrats (8)zu erkennen.

## Beschreibung

Die Erfindung betrifft eine Vorrichtung zum Laden von Substraten verschiendener Größe in Substrathalter.

Desweiteren betrifft die Erfindung ein Verfahren zum Laden von Substraten verschiedener Größe in einen dafür vorgesehenen Substrathalter.

Bei CD-Messsystemen (cd-critical distance), die für Durchlichtmessungen ausgerichtet sind, werden die Substrate in Rahmen transportiert. Üblicherweise werden hier die Masken von Hand und außerhalb des Messsystems in die Rahmen eingelegt. Die Rahmen werden dann mit eingelegten Substraten direkt auf den Messtisch (XY-Schlitten) eingeladen und auch entladen. Dies ist für die Anwendung in der Produktionsumgebung der Halbleiterhersteller nicht praktikabel. Das in der Leica® LMS IPRO der Fa. Leica Microsystems Wetzlar GmbH verwendetete Substrathandling-System ist zwar automatisiert, jedoch für große Substrate und auch für unterschiedliche Substrathalter nicht ausgelegt.

Der Erfindung liegt daher die Aufgabe zugrunde, eine Vorrichtung zu schaffen, mit der ein sicheres Einlegen verschiedener Substrate in ein Messgerät ermöglicht wird. Dabei ist ein sicherer Transfer der Substrate in das Messgerät von besonderer Bedeutung. Hinzu kommt, dass durch die Vorrichtung eine Beschädigung der Substrate durch eine falsche Handhabung mit den Substrathaltern vermieden werden soll.

Diese Aufgabe wird bei einer Vorrichtung der eingangs genannten Art erfindungsgemäß dadurch gelöst, dass eine Bodenplatte mit umlaufenden Rand vorgesehen ist. Auf der Bodenplatte sind mindestens drei Tragmittel angeordnet, von denen jedes unterschiedliche Auflageflächen für die verschiedenen Substrate ausgebildet hat. Dabei sind die Auflageflächen an den Tragmitteln stufenförmig angeordnet. Für den Substrathalter sind Aufnahmeelemente vorgesehen, die den Transportrahmen derart tragen, dass er die Tragmittel umschließt und in seiner Lage ausgerichtet ist.

Der Erfindung liegt weiterhin die Aufgabe zugrunde, ein Verfahren zu schaffen, mit dem das Einbringen von verschiedenen Substraten in ein Messgerät ermöglicht wird. Hinzu kommt, dass eine sichere und beschädigungsfreie Handhabung der verschiedenen Substrate gewährleistet ist.

Diese Aufgabe wird bei einem Verfahren der eingangs genannten Art erfindungsgemäß dadurch gelöst, dass das Verfahren folgende Schritte umfaßt:
- Bestimmen der Art des Substrathalters,
- Ablegen des Substrathalters auf den auf einer Bodenplatte der Vorrichtung vorgesehenen Tragmitteln,
- Einlegen eines Substrats auf dafür vorgesehene Tragmittel,
- Bestimmen der Größe des Substrats,
- Prüfen des Übereinstimmung zwischen Substrathalter und Substrat und
- Übernahme des Substrats in den für das Substrat vorgesehenen Substrathalter.

Vorteilhafte Weiterbildungen ergeben sich aus den Merkmalen der Unteransprüche.

Mit der erfindungsgemäßen Ausgestaltung einer Ladestation zum Einlegen der verschiedenen Substrate in einen Substrathalter wird es möglich, dass eine sichere oder automatisierte Handhabung der einzelnen Substrate durchgeführt werden kann. Hinzu kommt, dass die Ablage der Substrate in den Substrathalter die Substrate bereits ausrichtet und so in eine definierte Lage bringt. Dies hat den Vorteil, dass bei der Vermessung der Substrate von definierten Bedingungen ausgegangen werden kann. Die Substrate werden zusammen mit dem Substrathalter in das Messgerät überführt. Dies hat den Vorteil, dass das Substrat selbst nicht von einer Bedienperson per Hand in das Messgerät eingelegt werden muss. Es werden dadurch Temperaturgradienten im Substrat vermieden, die durch das Anfassen mit der Hand auftreten können.

In der Zeichnung ist der Erfindungsgegenstand schematisch dargestellt und wird anhand der Figuren nachfolgend beschrieben. Dabei zeigen
- ***Fig. 1:***: eine schematische Seitenansicht eines Messgerätes,
- ***Fig. 2:***: eine perspektivische Darstellung einer Ladestation,
- ***Fig. 3:***: eine Seitenansicht eines Tragmittels,
- ***Fig. 4:***: eine Draufsicht auf die verschiedenen Auflageflächen des Tragmittels,
- ***Fig. 5:***: eine perspektivische Darstellung eines in die Ladestation eingelegten Substrathalters, und
- ***Fig. 6:***: eine perspektivische Darstellung, bei der der Substrathalter zusammen mit dem Substrat von der Ladestation abgehoben ist.

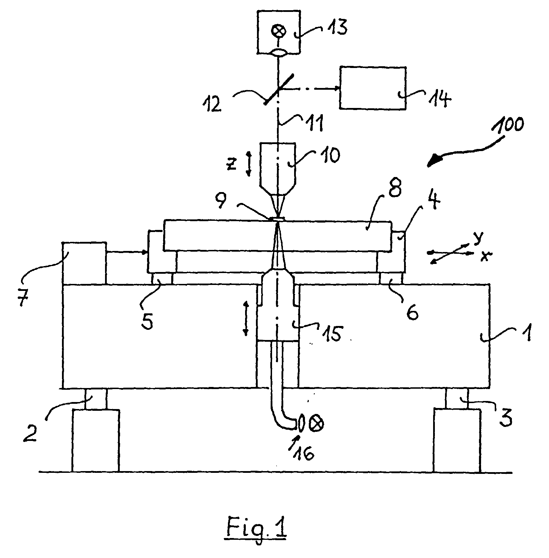

Das in ***Fig. 1*** dargestellte hochgenaue Messgerät 100 besteht aus einem Granitblock 1, der auf Füßen 2, 3 schwingungsgedämpft gelagert ist. Auf dem Granitblock 1 ist ein als Rahmen ausgebildeter XY-Schlitten 4 auf Luftlagern 5, 6 in den zwei durch Pfeile angedeuteten Richtungen gleitend verschiebbar. Der Rahmen des XY-Schlitten 4 besteht vorteilhafterweise aus einer Glaskeramik mit geringem thermischen Ausdehnungskoeffizienten. Die Antriebe dafür sind nicht dargestellt. Die Position des XY-Schlittens 4 wird mit einem Laser-Interferometer-System 7 in X- und Y-Richtung gemessen.

In den Rahmen des XY-Schlitten 4 ist ein Substrat 8 eingelegt. Das Substrat 8 besteht z.B. aus Quarzglas. Auf der Substratoberfläche sind Strukturen 9 aufgebracht. Da der XY-Schlitten 4 als Rahmen ausgebildet ist, kann das Substrat 8 auch von unten her durchleuchtet werden. Bei nicht lichtdurchlässigen Substraten findet dann eine Beleuchtung mit Auflicht Anwendung. Die weitere Beschreibung beschränkt sich auf die Beleuchtung von lichtdurchlässigen Substraten. Dies soll in keiner Weise als eine Beschränkung der Anmeldung aufgefasst werden.

Oberhalb des Substrats 8 befindet sich ein Abbildungssystem 10 hoher optischer Güte, das zur Fokussierung längs seiner optischen Achse 11 in Z-Richtung verstellbar ist. Über einen Teilerspiegel 12 wird zum einen das Licht einer Lichtquelle 13 in den optischen Strahlengang eingeleitet und zum anderen werden die Abbildungsstrahlen auf eine Detektor-Einrichtung 14 gelenkt. Die Detektor-Einrichtung 14 ist z.B. eine CCD-Kamera mit hochauflösendem Pixelarray. Die Lichtquelle 13 emittiert im nahen UV-Spektralbereich.

In den Granitblock 1 ist eine weitere Beleuchtungseinrichtung eingesetzt, die aus einem höhenverstellbaren Kondensor 15 und einer Lichtquelle 16 besteht. Als Lichtquelle 16 kann auch die Austrittsfläche eines Lichtleiters vorgesehen sein. Die optische Achse des Kondensors 15 fluchtet mit der optischen Achse 11 des Abbildungssystems 10. Die Höhenverstellung des Kondensors 15 mit Lichtquelle 16 dient der Anpassung der auf die Struktur 9 zu richtenden Beleuchtungsstrahlen an unterschiedliche optische Dicken der Substrate 8. Der Kondensorkopf kann insbesondere in den offenen Teil des Rahmens des XY-Schlittens 4 hineinreichen. Zum Schutz vor Beschädigungen bei Tischverschiebungen über die gesamte Substratfläche kann er unter die Oberfläche des Granitblocks 1 gezogen werden. Die Lichtquellen 13 und 16 sind voneinander unabhängig einschaltbar.

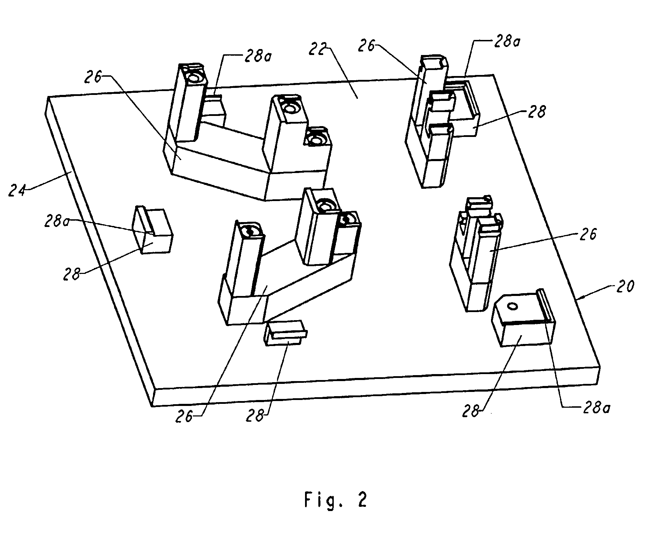

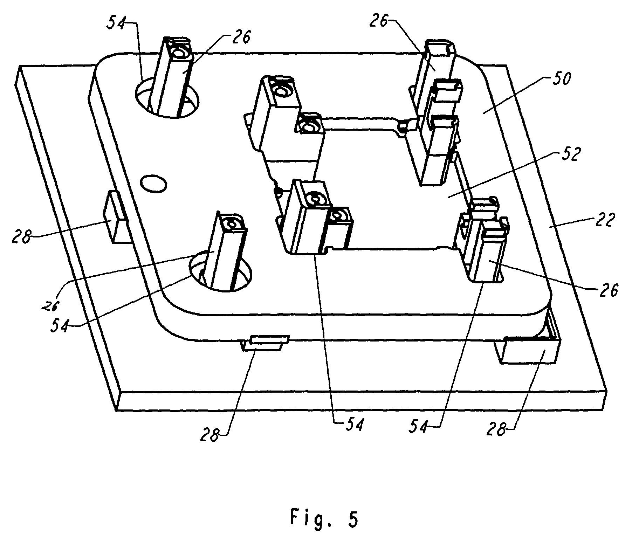

***Fig. 2*** zeigt eine perspektivische Darstellung der Ladestation 20. Die Ladestation weist eine Bodenplatte 22 auf, an der ein umlaufender Rand 24 ausgebildet ist. Auf der Bodenplatte 22 sind mehrere Tragmittel 26 angeordnet, die derart auf der Bodenplatte 22 verteilt sind, dass eine stabile Auflage für die Substrate 8 gewährleistet ist. Im vorliegenden Fall sind vier Tragelemente 26 vorgesehen. Es ist auch denkbar, dass lediglich drei Tragmittel 26 vorgesehen sind, die dann derart angeordnet sind, dass eine stabile und sichere Auflage für die Substrate 8 gewährleistet ist. Zusätzlich zu den Tragmittel 26 sind auf der Bodenplatte 22 Aufnahmeelemente 28 angebracht, die einen Substrathalter 50 (siehe ***Fig. 5***) derart tragen, dass er die Tragmittel 26 umschließt und in seiner Lage ausgerichtet und orientiert ist. Dazu sind an mehreren Aufnahmeelementen 28 Anschlagskanten 28a ausgebildet, die die definierte und genaue Lage des Substrathalters 50 gewährleisten. Die Aufnahmeelemente 28 sind im vorliegenden Ausführungsbeispiel derart auf der Bodenplatte 22 angeordnet, dass sie näher zum Rand 24 iiegen als die Tragmittel 26.

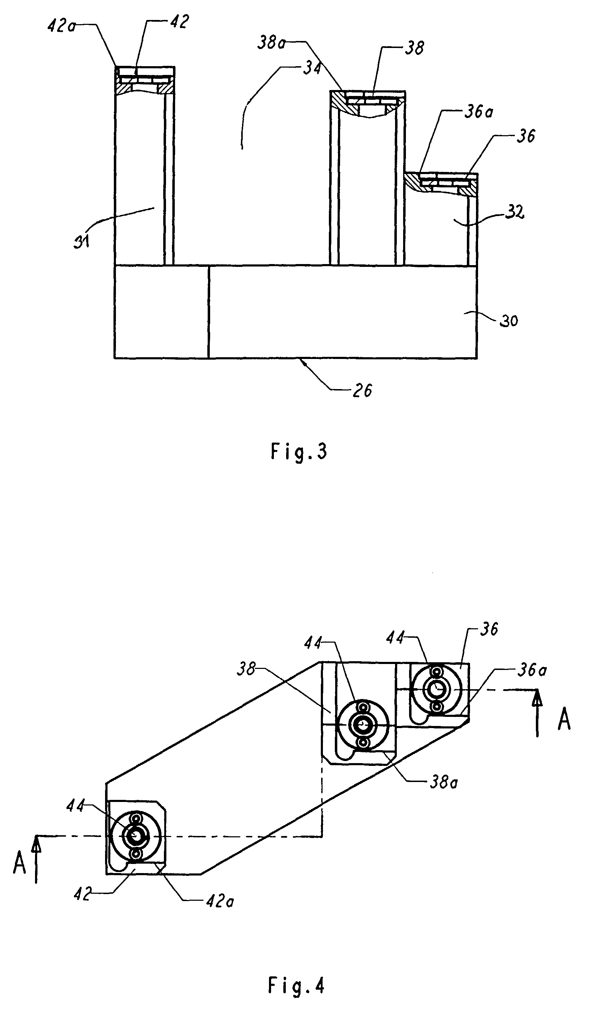

***Fig. 3*** zeigt die Seitenansicht eines Ausführungsbeispiels eines Tragmittels 26 entlang des Schnittes A-A aus ***Fig. 4***. Das Tragmittel 26 ist kann einstückig aus einem geeigneten Material gefertigt sein. Im vorliegenden Ausführungsbeispiel ist das Tragmittel 26 aus mehreren Einzelbauteilen zusammengesetzt. Ein Grundteil 30 trägt ein erstes und ein zweites Teil 31 und 32. Der erste und der zweite Teil 31 und 32 sind räumlich voneinander durch eine Aussparung 34 getrennt. In ***Fig. 3*** sind auf dem zweiten Teil 32 des Tragmittels 26 eine erste und eine zweite Auflagefläche 36 und 38 ausgebildet. Auf dem ersten Teil 31 des Tragmittels 26 ist eine dritte Auflagefläche 42 ausgebildet. Die Tragmittel 26 sind räumlich auf der Bodenplatte 22 derart angeordnet, dass die gleichen Auflageflächen 36, 38 40 oder 42 der verschiedenen Tragmittel 26 für die verschiedenen Substratgrößen jeweils eine stabile Halterung darstellen. Zur Begrenzung der ersten Auflagefläche 36 ist daran eine erste Anschlagskante 36a ausgebildet. Zur Begrenzung der zweiten Auflagefläche 38 ist daran eine zweite Anschlagskante 38a ausgebildet. Zur Begrenzung der dritten Auflagefläche 42 ist daran eine dritte Anschlagskante 40a ausgebildet. Zur Begrenzung der vierten Auflagefläche 42 ist daran eine vierte Anschlagskante 42a ausgebildet. Substrate, die mit dieser Vorrichtung vermessen werden können, müssen dem SEMI Standard (SEMI P1-92 © SEMI 1981, 1999) genügen. Einige Beispiel hierfür sind Quarzmasken vom Typ 6025 (6 X 6 Inch und 0,25 Inch dick), Typ 5009 (5 X 5 Inch und 0,09 Inch dick) oder die Quarzmaske mit den Abmessungen 230 X 230 X 9 Millimeter.

Eine Draufsicht auf die verschiedenen Auflageflächen 36, 38 und 42 des Tragmittels 26 ist in ***Fig. 4*** dargestellt. In dem hier dargestelltem Ausführungsbeispiel sind alle Anschlagskanten 36a, 38a und 42b winklig ausgeformt, um die Substrate 8 in einer stabilen Lage zu halten. Andere Ausgestaltungen der Anschlagskanten 36a, 38a und 42b sind vorstellbar und offensichtlich. In jeder der Auflageflächen 36, 38 und 42 ist ein Sensorelement 44 untergebracht, das feststellt, ob und welches Substrat 8 in die Ladestation 20 eingelegt wurde. Die Sensorelemente 44 müssen nicht auf den verschiedenen Auflageflächen 36, 38 und 42 eines einzelnen Tragmittels 26 vorgesehen sein. Es ist ebenso vorstellbar, dass jedes Tragmittel 26 ein Sensorelement 44 beinhaltet, das immer auf einer anderen Auflagefläche eingebaut ist. Geht man z.B. von vier Tragmitteln aus, so befindet sich beim ersten Tragmittel 26 das Sensorelement 44 in der ersten Auflagefläche 36, beim zweiten Tragmittel 26 in der zweiten Auflagefläche 38 und beim dritten Tragmittel 26 in der dritten Auflagefläche 42. Ebenso ist jede weitere Anordnung der Sensorelemente 44 denkbar, die eine Bestimmung zulassen, ob ein Substrat eingelegt ist. Die Sensorelemente 44 selbst können unterschiedliche Ausgestaltungen aufweisen, wie z.B.ein Kontaktschalter, ein kapazitiver Sensor oder ein optischer Sensor.

Bevor das Substrat 8 in die Ladestation 20 eingelegt wird, wird ein Substrathalter 50 in die Ladestation 20 eingebracht ***(Fig. 4)***. Im Substrathalter 50 ist eine Aussparung 52 definiert, die entsprechend der Länge und der Breite der verwendeten Substrate 8 bestimmt ist. Zusätzlich sind im Substrathalter 50 Führungsaussparungen 54 vorgesehen, die derart im Substrathalter 50 angeordnet sind, dass sie der räumlichen Anordnung der Tragmittel 26 auf der Bodenplatte 22 entsprechen. Beim Einsetzen des Substrathalters 50 in die Ladestation 20 greifen Teile der Tragmittel 26 in die Führungsaussparungen 54 des Substrathalters 50 ein und gewährleisten dadurch eine grobe Führung. Die Führungsaussparungen 54 sind derart bemessen, dass zwischen ihnen und dem Tragmittel 26 ein Spiel besteht. Ist der Substrathalter 50 in die Ladestation 20 eingesetzt, dann ruht er auf den Aufnahmeelementen 28, durch die er exakt ausgerichtet und positioniert wird.

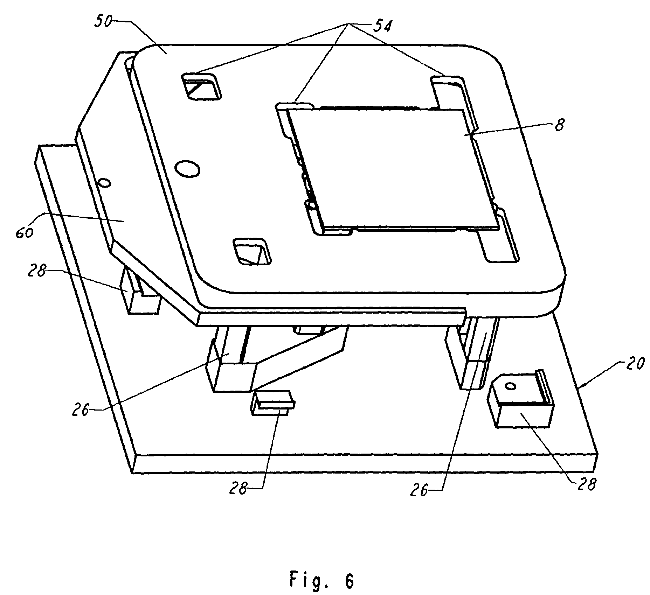

***Fig. 6*** stellt das Abheben des Substrathalters 50 zusammen mit einem eingelegtem Substrat 8 dar. Ist, wie bereits oben erwähnt, das zum verwendeten Substrathalter 50 geeignete Substrat 8 durch die Sensorelemente 44 (Fig. 4) festgestellt worden, kann der Substrathalter 50 von der Ladestation 20 abgehoben werden. Hierzu fährt eine Gabel 60, die an einem Roboterarm (nicht dargestellt) angebracht ist, unter den Substrathalter 50, der auf den Aufnahmeelementen 28 ruht. Durch die Hubbewegung des Roboterarms (nicht dargestellt) hebt die Gabel 60 den Substrathalter 50 an, der dabei das in der Ladestation 20 befindliche Substrat 8 mitnimmt. Das Substrat 8 kommt in der Aussparung 52 des Substrathalters 50 zu liegen. Ebenso werden durch die Hubbewegung des Roboterarms (nicht dargestellt) die Tragmittel 26 der Ladestation 20 aus den Führungsaussparungen 54 des Substrathalters 50 herausbewegt. Die Einheit Substrathalter 50 und Substrat 8 kann nun durch den Roboterarm 60 in das hochgenaue Messgerät 100 oder in ein Magazin (nicht dargestellt) überführt werden.

Die vorliegende Erfindung ist in Bezug auf Ausführungsbeispiele beschrieben worden. Es ist jedoch für jeden auf diesem Fachgebiet tätigen Fachmann offensichtlich, dass Änderungen und Abwandlungen vorgenommen werden können, ohne dabei den Schutzbereich der nachstehenden Ansprüche zu verlassen.

### Bezugszeichenliste

- 1: Granitblock
- 2: Fuß
- 3: Fuß
- 4: XY-Schlitten
- 5: Luftlager
- 6: Luftlager
- 7: Laser-Interferometer
- 8: Substrat
- 9: Strukturen
- 10: Abbildungssystem
- 11: optische Achse
- 12: Teilerspiegel
- 13: Lichtquelle
- 14: Detektor-Einrichtung.
- 15: höhenverstellbarer Kondensor
- 16: Lichtquelle
- 20: Ladestation
- 22: Bodenplatte
- 24: Rand
- 26: Tragmittel
- 26a: Innenfläche
- 26b: Außenfläche
- 28: Aufnahmeelemente
- 28a: Anschlagskanten
- 30: Grundteil
- 31: erster Teil
- 32: zweiter Teil
- 34: Ausfräsung
- 36: erste Auflagefläche
- 36a: erste Anschlagskante
- 38: zweite Auflagefläche
- 38a: zweite Anschlagskante
- 42: dritte Auflagefläche
- 42a: dritte Anschlagskante
- 44: Sensorelement
- 50: Substrathalter
- 52: Aussparung
- 54: Führungsaussparungen
- 60: Gabel

## Patentansprüche

1. Vorrichtung zum Laden von Substraten (8) verschiedener Größe in einen Substrathalter (50) **gekennzeichnet durch**:
a) eine Bodenplatte (22) mit umlaufenden Rand (24),
b) mindestens drei auf der Bodenplatte (22) angeordnete Tragmittel (26), von denen jedes unterschiedliche Auflageflächen (36, 38 und 42) für die verschiedenen Substrate (8) ausgebildet hat, wobei die Auflageflächen (36, 38 und 42) an den Tragmitteln (26) stufenförmig angeordnet sind, und
c) Aufnahmeelemente (28) für den Substrathalter (50), die den Substrathalter (50) derart tragen, dass er die Tragmittel (26) umschließt und in seiner Lage ausgerichtet ist.

2. Vorrichtung nach Anspruch 1, **dadurch gekennzeichnet,** dass die Auflageflächen (36, 38, 40 und 42) durch Anschläge (36a, 38a und 42a) derart begrenzt sind, dass die verschiedenen Substrate (8) ausgerichtet sind.

3. Vorrichtung nach Anspruch 1, **dadurch gekennzeichnet,** dass in mindestens einer der Auflageflächen (36, 38, 40 und 42) eines Tragmittels (26) für eine Substratgröße mindestens ein Sensorelement (44) untergebracht ist.

4. Vorrichtung nach Anspruch 1, **dadurch gekennzeichnet,** dass mindestens ein weiteres Sensorelement vorgesehen ist, daß bei Substraten gleicher Größe deren unterschiedlichen Dicken erkennbar sind.

5. Vorrichtung nach Anspruch 1, **dadurch gekennzeichnet,** dass die Substrathalter (50) für die verschiedenen Substratgrößen gleiche Außenabmessungen aufweisen.

6. Verfahren zum Laden von Substraten verschiedener Größe in einen dafür vorgesehenen Substrathalter (50) **gekennzeichnet durch** folgende Schritte:
a) Bestimmen der Art des Substrathalters (50),
b) Ablegen des Substrathalters (50) auf den auf einer Bodenplatte (22) der Vorrichtung vorgesehenen Tragmitteln (26),
c) Einlegen eines Substrats auf dafür vorgesehene Tragmittel (26),
d) Bestimmen der Größe des Substrats (8),
e) Prüfen des Übereinstimmung zwischen Substrathalter (50) und Substrat (8) und
f) Übernahme des Substrats in den für das Substrat vorgesehenen Substrathalter (50).

7. Verfahrennach Anspruch 6, **dadurch gekennzeichnet,** dass das Einlegen des Substrats (8) in die dafür vorgesehenen Tragmittel (26) durch eine Bedienperson per Hand erfolgt.

8. Verfahrennach Anspruch 6, **dadurch gekennzeichnet,** dass das Einlegen des Substrats (8) in die dafür vorgesehenen Tragmittel (26) durch eine automatisierte Vorrichtung erfolgt.

9. Verfahren nach Anspruch 6, **dadurch gekennzeichnet,** dass der Schritt des Bestimmens der Art des Substrathalters (50) mittels einer Kodierung erfolgt, die am Substrathalter (50) vorgesehen ist.

10. Verfahren nach Anspruch 9, **dadurch gekennzeichnet,** dass der Schritt des Bestimmens des Substrattyps (8) mittels Sensorelementen (44) erfolgt, die in den Auflageflächen der Tragmittel vorgesehen sind.
